# EUROPEAN PATENT SPECIFICATION

(11) **EP 3 796 556 B1**
(45) Date of publication and mention of the grant of the patent: **08.07.2026**
(21) Application number: 19306124.9
(22) Date of filing: 18.09.2019
(51) Int. Cl.: H03H 9/02, H03H 9/145, H03H 9/64

(54) **TRANSDUCER STRUCTURE FOR AN ACOUSTIC WAVE DEVICE**
WANDLERSTRUKTUR FÜR EINE AKUSTIKWELLENVORRICHTUNG
STRUCTURE DE TRANSDUCTEUR POUR DISPOSITIF D'ONDE ACOUSTIQUE

(43) Date of publication of application: 24.03.2021
(73) Proprietor: Soitec, 38190 Bernin (FR)
(72) Inventor: BALLANDRAS, Sylvain, 25000 Besançon (FR); COURJON, Emilie, 25770 Franois (FR); BERNARD, Florent, 25000 Besançon (FR)
(74) Representative: Grünecker Patent- und Rechtsanwälte PartG mbB

(56) References cited:
- DE-T5- 112017 005 984
- JP-A- H09 167 935
- US-A1- 2002 153 969
- US-A1- 2011 199 168
- US-A1- 2014 203 893
- US-A1- 2018 375 491
- US-A1- 2019 319 603
- REITZ DANIEL ET AL: "Damascene technique applied to surface acoustic wave devices", JOURNAL OF VACUUM SCIENCE AND TECHNOLOGY: PART B, AVS / AIP, MELVILLE, NEW YORK, NY, US, vol. 25, no. 1, 30 January 2007 (2007-01-30), pages 271 - 276, XP012102822, ISSN: 1071-1023, DOI: 10.1116/1.2404684
- HIRABAYASHI M: "OPTIMIZATION OF SURFACE-ACOUSTIC-WAVE WITHDRAWAL-WEIGHTED FILTERS USING SIMULATED ANNEALING", JAPANESE JOURNAL OF APPLIED PHYSICS, JAPAN SOCIETY OF APPLIED PHYSICS, JP, vol. 36, no. 8, PART 01, 1 August 1997 (1997-08-01), XP000749061, ISSN: 0021-4922, DOI: 10.1143/JJAP.36.5371

## Description

The invention relates to acoustic wave devices, in particular to transducer structures for an acoustic wave device.

In recent years, surface acoustic wave (SAW) devices have been employed in an increasing number of practical applications, such as filters, sensors and delay lines. In particular, SAW filters are interesting for mobile phone applications due to their ability to form low loss high order bandpass filters without employing complex electrical circuits with unprecedented compactness. Therefore, SAW filters provide significant advantages in performance and size over other filter technologies.

In a typical surface acoustic wave device, one or more inter-digitated transducers (IDTs) are formed over a surface propagating substrate and are used to convert acoustic waves to electrical signals and vice versa by exploiting the piezoelectric effect of the substrate. An inter-digitated transducer (IDT) comprises opposing "electrode combs" with inter-digitated metal fingers disposed on a piezoelectric substrate. A Rayleigh surface acoustic wave develops on the substrate by electrically exciting the fingers. The other wave types, shear and longitudinally polarized wave, travel in the volume and get absorbed, thus requiring optimized metal grating thicknesses to be used for filter applications. Conversely, an electrical signal can be induced across the fingers by a surface acoustic wave propagating in the piezoelectric substrate material beneath the transducer. Examples of SAW devices are shown in US 2011/199168 A1, US 2014/203893 A1, JP H09 167935 A or DE 11 2017 005984 T5.

SAW devices commonly use wafers made from a monolithic Quartz, LiNbO₃ or LiTaO₃ crystals as piezoelectric materials. However, the use of piezoelectric substrates leads to either high sensibility to temperature in the case of LiNbO₃ or LiTaO₃ or weak electromechanical coupling in the case of Quartz depending on the piezoelectric material used.

Furthermore, elastic wave velocities are generally limited by the single crystal material properties, particularly considering phase velocity which remains between 3000 and 4000m/s most of the time. Indeed, in the case of Quartz, Rayleigh surface acoustic waves are the most used modes and their phase velocity ranges from 3000 to 3500 m.s⁻¹. The use of shear waves allows for phase velocity up to 5100 m.s⁻¹. In Quartz, coupling is limited to 0.5%. In the case of Lithium Tantalate, Rayleigh waves exhibit phase velocity in the range 3000-3500 m.s⁻¹ but the mode coupling may reach 2%. Rayleigh waves on Lithium Niobate reach phase velocities up to 3900m.s⁻¹ with a coupling factor of 5.6%, potentially achieving 8% with using a SiO₂ passivation layer above the IDTs.

Shear waves also called pseudo modes, on LiTaO₃ and LiNbO₃ are exhibiting radiation leakage, so called leaky modes. In that case, the surface is partially guiding the waves. Therefore, the electrode grating plays a major role in trapping the energy close to the surface. The phase velocity is in the range of 4000-4500 m.s⁻¹ for both materials.

Finally, compressional modes can also be excited on LiTaO₃ and LiNbO₃ substrates along certain crystal cuts but also here, the modes are leaky by nature, thus requiring specific electrode thicknesses vs frequency to minimize leakage effects due to wave radiation into the bulk.

One approach to overcome the leakage effects has led to the use of composite substrates. A composite substrate comprises a piezoelectric layer formed over a base substrate. A composite substrate gives a large choice of materials for the base substrate and base substrate materials with a high acoustic wave propagation velocity can be chosen, such as Diamond, Sapphire, Silicon Carbide or Silicon. Similar to optics, the use of such a base substrate leads to the guidance of the mode.

Composite substrates can combine strong electro mechanical coupling, i.e. an electromechanical coefficient *kₛ²* larger than 1%, and temperature stability, i.e. a temperature coefficient of frequency (TCF) smaller than 20ppm/K, and can improve the performance of the SAW devices and provide flexibility of design.

However, acoustic wave devices are limited to operating frequencies from about 1 to 3 GHz, as for the given phase velocities, the electrode pitch *p* of the comb electrodes determines the wavelength *λ* of the acoustic wave given by the relation *p=λ*/*n,* with *n* ≧ 2, generally equal to 2. Operation at frequency above 2 GHz requires metal dimension and thickness of the order or below 100nm, which present stability problems of the structure. Thus, in practice, it is difficult to further miniaturize comb electrodes when higher operating frequencies are required. This is on the one hand due to the need to use higher resolution lithography technology compared to the I-line lithography used today in SAW industry, and on the other hand due to electric losses occurring in the structure.

Therefore, to create SAW devices above 3 GHz, a strong technological effort is required.

The object of the invention is thus to overcome the drawbacks cited previously by providing an inter-digitated transducer structure for an acoustic wave device with improved parameters and to provide an acoustic wave device that can function for frequencies exceeding 3GHz but that can still be manufactured using standard I-line lithography. There is furthermore a second object of the invention to provide a transducer structure with which the transfer function can be adapted to specific needs.

The second object of the invention is achieved by a transducer structure for an acoustic wave device according to claim 1. By having neighbouring electrode means linked to the same potential, but still having the same mechanical periodicity, acoustic sources are removed from the system so that the electro mechanical coupling is reduced. This can be used to tailor the electro mechanical coupling and thereby, when forming filters, adjusting the transfer function of a filter, namely by fine-tuning the width of the band pass. By embedding the electrodes more stability of the electrodes can be obtained.

According to a variant, the acoustic impedance of the electrode means can be less than the acoustic impedance of the piezoelectric layer.

Here, because the electrode means are embedded in the piezoelectric layer and with the acoustic impedance of the electrode means being smaller than the one of the piezoelectric layer a shear wave like propagating mode essentially limited to the volume of the electrode means, can be excited. Actually, the boundary conditions are such that is becomes possible to excite that shear mode within the electrode means. Due to the acoustic impedance contrast, the reflection at the lateral edges of the electrode means is large enough to essentially confine the energy within the electrode, Due to the grating configuration by the interdigitated comb electrodes and in the presence of an alternating electrical polarity, some vibration is nevertheless induced within the piezoelectric layer that leads to a coherence between the vibration of the electrodes, which leads to the resonance phenomenon with phase vibration from one electrode the next neighbouring electrode being opposite. The operating acoustic wavelength λ of the transducer is linked to the resonant frequency *fᵣ* of the transducer structure as *fᵣ* = v / *2p* = *v* / *λ, v* being the acoustic wave propagation velocity in the acoustic wave propagating substrate. Thus, in the given geometry much higher equivalent phase velocities, e.g. even of the order of 10.000m.s⁻¹ can be observed than mentioned above. Since the bulk acoustic wave inside the electrode means has a resonance at higher frequency compared to the guided wave in the piezoelectric layer in prior art constellations as described above, this mode allows the transducer structure to function at higher frequencies above 3 GHz, without
being at the limit of the fabrication technology of I-line lithography compared to state of the art transducer structure.

In particular, the ratio between acoustic impedance of the electrode means to the piezoelectric layer is preferably less than 0.5. Material combinations yielding an electro mechanical coupling of more than 2%, preferably more than 3%, favor the establishment of the mode inside the electrodes and a coherent coupling between the electrodes.

According to a variant of the invention, the metallization ratio a/p of the electrode means, with "a" the width and "p" the pitch of the electrode means, can be comprised between 0,3 and 0,75, in particular between 0,4 and 0,65. Using an a/p ratio in this range favors the formation of the excited bulk acoustic wave in the electrode means, and reduces or suppresses the contribution of the acoustic surface mode of the piezoelectric layer.

According to a variant of the invention, the piezoelectric layer can be provided over a base substrate. Using a base substrate favors the confinement of energy near the surface and in particular inside the electrode means.

According to the invention, the thickness of the embedded electrode means is equal to the thickness of the piezoelectric layer. Thus, thicker electrodes compared to state of the art transducer structure are used and thereby, besides allowing the establishment of the shear mode in the electrodes, the stability of the electrodes can be increased and Ohmic losses reduced.

According to the invention, the acoustic impedance of the base substrate of the composite substrate is within plus/minus 25% of the acoustic impedance of the piezoelectric layer, more in particular within 15%. In particular, in case the electrodes have the same thickness as the piezoelectric layer, the impedance matching allows the confinement of the shear mode in the electrodes.

According to a variant of the invention, the thickness tₑ of the electrode means satisfies λ > *tₑ* > 0,1*λ. In this thickness range, it becomes possible to concentrate the electromechanical field near the surface, in a region of thickness comparable to that of the electrode for single crystal or of that of the piezoelectric layer plus electrode for composite wafers. This will result in an improved electromechanical coupling and spectral purity allowing for single or at least limited number of, mode contribution to the device response.

According to a variant of the invention, the transducer structure can further comprise a Bragg mirror underneath the piezoelectric layer and/or underneath the embedded electrode means. A Bragg mirror reduces energy loss towards the base substrate, and can add mechanical stability to the device structure.

According to a variant of the invention, a covering layer can be provided on top of the embedded electrode means and the piezoelectric layer. This further improves guiding of the shear mode in the electrodes and further reduces the possibility of electro migration.

According to a variant, the embedded electrodes can be filled into pyramidal or V- or U-shaped grooves in the piezoelectric layer and/or wherein the side walls of the grooves have a convex or concave shape. In particular, the pyramidal shape of the electrodes leads to improved quality factors compared to grooves with vertical walls.

According to a variant, the material of the electrode means can be made of a material that is lighter than Manganese, in particular Aluminum or an aluminum alloy comprising Cu, Si or Ti. In particular, the combination of Aluminium with Lithium Tantalate yields at coupling factors of more than 3% while the fundamental shear mode in the piezoelectric layer is absent.

According to a variant, the base substrate and/or the covering layer is Silicon dioxide or glass or quartz or LiTaO₃ or LiNbO₃. Using these substrates, the shear mode inside the electrode means remains, whereas the fundamental shear mode in the piezoelectric layer is suppressed. At the same time piezoelectric layer on glass or SiO₂ substrates can be obtained in an industrial scale, e.g. by the so called piezoelectric-on-insulator (POI) substrates.

According to a variant regions with two or more neighbouring electrode means can belong to the same comb electrode are not periodically distributed, in particular are randomly distributed. By reducing the symmetry of the system, spurious contributions of higher order periodicities can be reduced or even suppressed.

According to a variant regions (1218) with two or more neighbouring electrode means belonging to the same comb electrode can have different numbers of neighbouring electrode means belonging to the same comb electrode. By having regions with different numbers of neighbouring electrode means connected to the same potential spurious contributions can be further reduced.

The object of the invention is also achieved with an acoustic wave device comprising at least one transducer structure as described previously, in particular, an acoustic wave resonator, and/or an acoustic wave filter and/or an acoustic wave sensor. The acoustic wave device, which can be operated at frequencies of more than 3 GHz can be manufactured using i-line lithography technology without using further advanced and therefore more expensive lithography tools. Thus, compared to a Rayleigh surface wave using SAW device, which has its frequency limited to at most 2GHz, using the electrode shear wave mode allows extending the frequency range without having to change the patterning technology. When using composite substrates a reduced first order temperature coefficient of frequency (TCF) smaller than 20ppm/K can be achieved, resulting in device performances being stable with temperature. Using the invention, acoustic wave bandpass filter with relative bandwidths larger than 5% or even 10% and up to 15% can be achieved.

According to a variant, the acoustic wave device can comprises input and output transducer structures as described previously.

The object of the invention is also achieved with a method of using a transducer structure as described above, comprising a step of applying an alternating potential to the two interdigitated electrodes to excite a shear mode predominantly or exclusively occurring within the electrode means compared to the piezoelectric layer and having an equivalent velocity higher than the fundamental shear wave mode of the piezoelectric layer. The use of the higher frequency of the shear wave propagating in the electrode means of the transducer structure as described previously, in particular for a ladder filter and/or impedance filter and/ coupling filter, leads to devices that function above 3GHz, more in particular above 3.5GHz.

The invention may be understood by reference to the following description taken in conjunction with the accompanying figures, in which reference numerals identify features of the invention.
[Fig. 1] illustrates an inter-digitated transducer structure on a composite substrate for acoustic wave devices according to a first embodiment of the invention.
[Fig. 2] illustrates schematically the mode obtained with the transducer structure illustrated in Fig. 1.
[Fig. 3a] shows the simulated wide band harmonic admittance of an excited mode according to an example of the first embodiment of the invention.
[Fig. 3b] shows a mesh view illustrating the vibration of the mode observed.
[Fig. 3c] shows a mesh view illustrating the vibration of the mode at phase opposition.
[Fig. 3d] shows a zoom of the simulated wide band harmonic admittance of the excited mode as shown in Fig. 3a.
[Fig. 3e] shows the conductance and resistance of the excited mode.
[Fig. 3f] shows the dispersion properties of the excited mode
[Fig 4a to 4c] illustrates three different electrode shapes within a piezoelectric layer
[Fig 4d] illustrates the harmonic susceptance corresponding to the three different electrode geometries.
[Fig 4e] illustrates the harmonic conductance corresponding to the three different electrode geometries.
[Fig. 5] illustrates the effect of the thickness of the electrodes on the occurrence of the shear mode confined within the electrodes.
[Fig. 6] illustrates an inter-digitated transducer structure for acoustic wave devices according to a fourth embodiment of the invention.
[Fig. 7a] illustrates an inter-digitated transducer structure for acoustic wave devices according to a fifth embodiment of the invention.
[Fig. 7b] shows the simulated wide band harmonic admittance of an excited mode according to the fifth embodiment of the invention.
[Fig. 7c] shows the simulated wide band harmonic admittance of an excited mode according to a variant of the fifth embodiment of the invention.
[Fig. 7d] shows the simulated wide band harmonic admittance of an excited mode according to a variant of the fifth embodiment of the invention.
[Fig. 8] shows a sixth embodiment of the transducer structure according to any of the first and second embodiments of the invention.
[Fig. 9a] illustrates a seventh embodiment of the invention and relates to a filter at 5GHz.
[Fig 9b] illustrates the transfer function of the filter according to Fig. 9a.
[Fig. 10a] illustrates a higher order mode according to the invention.
[Fig 10b] illustrates the harmonic conductance and resistance of this mode for LiTaO₃ and SiO₂ substrates.
[Fig 10c] illustrates the harmonic conductance and resistance of this mode for Al₂O₃ and Si substrates.
[Fig. 11] illustrates an eighth embodiment of the invention with suppressed acoustic sources.

The invention will now be described in more detail using advantageous embodiments in an exemplary manner and with reference to the drawings. The described embodiments are merely possible configurations according to the invention and it should be borne in mind that the individual characteristics as described above can be provided independently of one another or in combination to achieve further embodiments according to the invention.

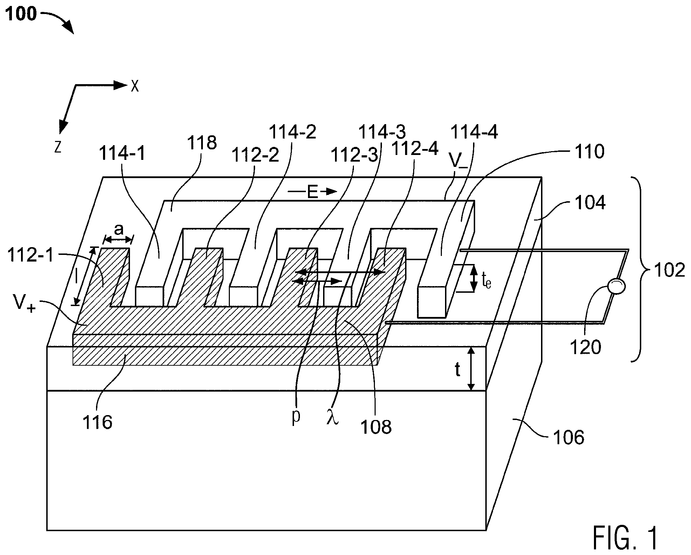

Fig. 1a illustrates an inter-digitated transducer structure for acoustic wave devices according to a first embodiment of the invention.

The transducer structure 100 comprises an acoustic wave propagating substrate 102. The acoustic wave propagating substrate is a composite substrate 102, comprising a piezoelectric layer 104 formed on top of a base substrate 106. The composite substrate can be a so-called piezoelectric-on-insulator substrate or POI substrate. In other embodiments, the piezoelectric layer can be so thick to form a bulk material.

The piezoelectric layer 104 herein described by way of example may be Lithium Niobate (LiNbO₃) or Lithium Tantalate (LiTaO₃). The piezoelectric material layer 104 can be attached to the base substrate 106 by direct bonding e.g. using a SmartCut^{™} layer transfer technology. The thickness of the piezoelectric layer 104 formed on the base substrate 106 is of the order of one wavelength λ or smaller, in particular is of about 2 µm or less, in particular less than 0,5λ, even more in particular less than 0,4λ.

The piezoelectric layer herein described by way of example may be Lithium Niobate (LiNbO₃), in particular LiNbO₃ with a crystal orientations defined according to standard IEEE 1949 Std-176 as (YX*l*)/∂ with 36°<∂<52° or 60°<∂<68° or 120°<∂<140° and as (YXt)/ Ψ with 85°< Ψ < 95° and as (YX*wlt*)/Φ∂Ψ with Φ =90°, -30°<∂<+45° and 0°< Ψ <45° or Lithium Tantalate (LiTaO₃), in particular LiTaO₃ with a crystal orientation defined according to standard IEEE 1949 Std-176 as (YX*l*)/∂ with 36°<∂<52°, more in particular LiTaO₃ with a 42° Y-cut, X-propagation, defined as (YX*l*)/42° cut according to standard IEEE 1949 Std-176.

As already mentioned, according to a variant, the thickness of the piezoelectric layer 104 can be superior to the wavelength λ, so that a piezoelectric layer thickness equivalent to a bulk piezoelectric material can also be used.

The base substrate 106 used in the first embodiment of the invention is a Silica substrate. Silica, quartz, fused quartz or glass. For this kind of substrate the slow shear bulk wave velocity (SSBW) is inferior to the one of the fundamental acoustic bulk shear mode in the piezoelectric layer so that the bulk shear mode of the piezoelectric layer is suppressed by radiation from the surface to the bulk and diffusion.

Other substrates with a high acoustic wave propagation velocity equal or larger than 4500m/s, like silicon, diamond, sapphire, silicon carbide or aluminium nitride may be used but in that case the fundamental guided shear mode, corresponding to the one excited when electrodes are positioned on top of the piezoelectric layer, can exist.

In this embodiment, the thickness of the base substrate 106 is larger than the thickness of the piezoelectric layer 104. A preferred situation corresponds to a base substrate thickness that is at least ten times larger than the thickness of the piezoelectric layer 104, in particular 50 to 100 times larger.

Furthermore, the acoustic impedance of the base substrate 106 of the composite substrate 102 is as defined in claim 1.

In a variant of the invention, the base substrate 106 may further comprise a trap-rich layer close to the top layer of piezoelectric material. Such a trap-rich layer can improve the isolation performance of the base substrate and may be formed by at least one of polycrystalline, amorphous, or porous materials such as for instance polycrystalline Silicon, amorphous Silicon, or porous Silicon. Under the term "trap-rich" one understands a layer that can absorb electrical charges without, however, forming a conductive layer.

The composite substrate can be obtained by a layer transfer method whereby a piezoelectric layer is transferred to a base substrate. Methods like bonding and thinning or a layer transfer method like SmartCut allowing subwavelength layer transfer can be used. Such composite substrate may comprise an additional layer or layer stacks as for instance bonding layers, in particular SiO₂, or other functional layers, e.g. trap-rich, Bragg mirror, low velocity/high velocity stack.

In a variant, the base substrate 106 may be a semiconductor on insulator (SOI) substrate. A Silicon on Insulator substrate (SOI) is built by molecular adhesion for instance using an intermediate SiO₂ (bonding) layer and a mean to transfer a Silicon layer such as the said Smart-Cut^{™} process.

The transducer structure 100 further comprises a pair of opposing inter-digitated comb electrodes 108 and 110, each of which has a plurality of electrode means, 112_i and 114_j (here 1 <= l,j <=4) respectively, extending from their respective conducting portion 116 and 118 and being inter-digitated with each other. The comb electrodes 108 and 110 and in particular the electrode means 112_i, 114_j are formed of any suitable conductive metal as long as the acoustic impedance is lower than in the piezoelectric layer 104, for example pure Aluminium or alloy such Al doped with Cu, Si or Ti. In general, electrode materials that are lighter than Manganese, thus starting from Chromium or lighter are suited. According to this embodiment, the aspect ratio *a*/*p,* with a the width and *p* the pitch of the electrode means 112_i, 114_j is comprised between 0,3 and 0,75, in particular between 0,4 and 0,65. The metallization or aspect ratio a/p and the thickness *tₑ* of the electrode means 112_i, 114_j are the parameter to control radiation losses and electromechanical coupling in the device.

An electrical load 120 is illustrated as being coupled across the comb electrodes 108, 110. However, it will be understood that a source potential 120 may also be coupled across the electrodes 108, 110, depending upon whether the transducer 100 is utilized to excite acoustic waves in the substrate 102 or to convert received acoustic waves to electrical signals, or both. The electrode means, for example 112_1 to 112_4 and 114_1 - 114_4 are inter-digitated and are connected to alternating potentials via their respective comb electrodes 108 and 110. The alternating potential can be +V and -V as illustrated or a mass and a load/source potential.

In this embodiment, the electrode means 112_i, 114_j all have the same length *l*, width *a*, and thickness *tₑ*. According to a variant of the invention, the electrode means 112_i, 114_j can also have different length *l* and/or width a and/or thickness *tₑ.*

Furthermore, an electrode pitch *p*, defined as λ/2, λ being the operating wavelength of the acoustic wave, is used for the transducer structure 100, corresponding to the Bragg condition. The electrode pitch *p* corresponds to the distance between two neighbouring electrode means from opposite comb electrodes 108 and 110, e.g. between 112_3 and 114_3. In this case, the wavelength *λ* corresponds to the distance between two neighbouring electrode means from the same comb electrodes 108 or 110, e.g. between 112_3 and 112_4. In such Bragg condition, the transducer is said to be working in a synchronous mode at the operating frequency *fᵣ*, where all the excited acoustic waves in the transducer structure are coherent and in phase. Thus, the electrode pitch *p* defines the frequency of utilisation of the transducer structure. The operating frequency *fᵣ* is fixed by the condition of phase agreement given by *v*/*2p, v* being the effective phase velocity of the acoustic wave propagating in the transducer structure 100 and *p* the electrode pitch of the transducer structure 100.

The electrode means 112_i, 114_j are embedded in the piezoelectric layer 104, so that their thickness *tₑ* is equal to the thickness t of the piezoelectric layer 104.

The thickness of the electrode means 112_i to 114_j should satisfy the following relationship with respect to the wavelength λ: 0,1 < tₑ/λ < 1.

Therefore, the electrode means 112_i to 114_j are thicker than the electrodes of state of the art inter-digitated transducer structures with the interdigitated electrodes formed over the piezoelectric substrate. They therefore offer a better stability and reduced electric losses. Furthermore, power handling is improved as embedded electrodes limit the possibility of acousto-migration and electro-migration due to power effects. The metal is located in a groove, which prevents direct metal contact due to surface diffusion and metal migration.

The conducting portions 116, 118 of the comb electrodes 108, 110 can be provided on the piezoelectric layer 104 and/or the embedded electrode means 112_i, 114_j.

The charge distribution in the electrodes 108 and 110 of the transducer structure 100 excites an acoustic wave in the electrical field direction, meaning perpendicularly to the extension direction z of the electrode means 112_i, 114_j of the electrodes 108, 110, as shown by the arrow E in fig. 1a.

In SAW devices of the art different modes can exists, e.g. Rayleigh surface acoustic waves, Lamb waves or shear waves. In contrast thereto, the inventive transducer structure 100 enables a new mode which leads to a shear like mode that is mainly concentrated inside the electrodes.

This is due to the fact that the electrode means are embedded in the piezoelectric layer and in that the acoustic impedance of the electrode means being smaller than the one of the piezoelectric layer. Actually, the boundary conditions are such that is becomes possible to excite that shear mode within the electrode means. The maximum of the vibration occurs in the centre of the electrodes and are changing signs from one electrode means to the next neighbouring electrode means.

Due to the acoustic impedance contrast, the reflection at the lateral edges of the electrode means is large enough to essentially confine the energy within the electrode. Due to the grating configuration by the interdigitated comb electrodes and in the presence of an alternating electrical polarity, some vibration is nevertheless induced within the piezoelectric layer that leads to a coherence between the vibration of the electrodes, which leads to the resonance phenomenon but still guidance of the mode can be obtained.

The operating acoustic wavelength *λ* of the transducer is linked to the resonant frequency *fᵣ* of the transducer structure as *fᵣ = v*/*2p = v*/*λ, v* being the acoustic wave propagation velocity in the acoustic wave propagating substrate.

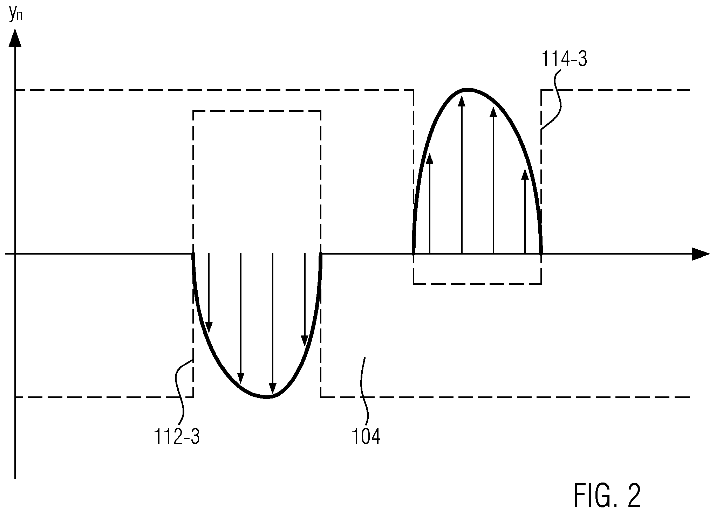

The mode is schematically illustrated in Fig. 2, which is a top view onto the transducer structure 100a and the two neighboring electrode means 112_3 and 114_3. Numerical simulations were realized, see S. Ballandras et al, Finite-element analysis of periodic piezoelectric transducers Journal of Applied Physics 93, 702 (2003); https://doi.org/10.1063/1.1524711 and have evidenced the excitation of this mode in which shear movement is concentrated within the electrode means.

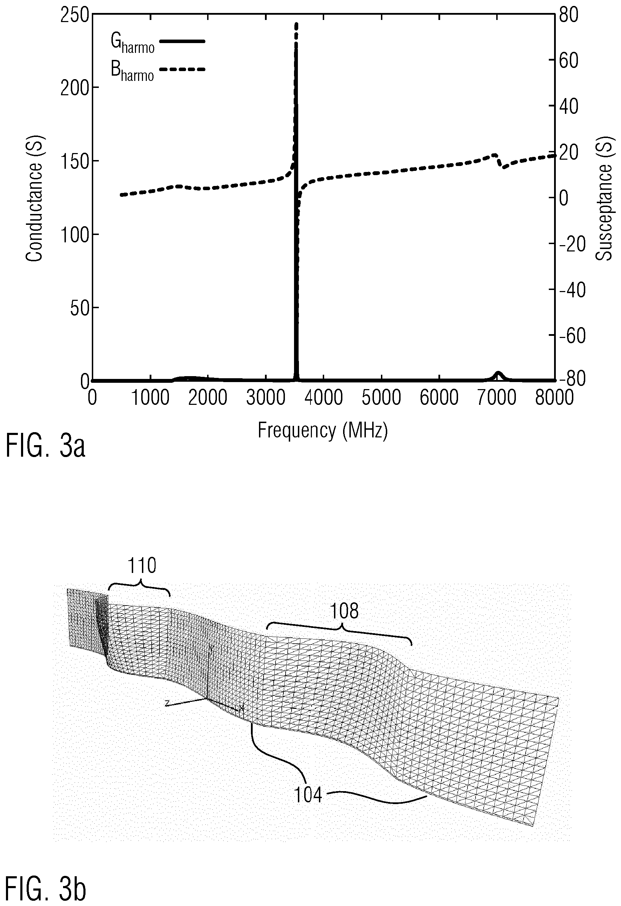

Fig. 3a shows the simulated wide band harmonic admittance of an excited mode according to an example of the first embodiment of the invention.

For this embodiment, the transducer structure comprises Al-Cu electrodes embedded in a LiTaO₃ piezoelectric layer over a Silica substrate. The wavelength λ of the transducer structure is equal to 2.8µm, thus p=1.4µm and the aspect ratio a/p of the electrodes is equal to 0.43. In this embodiment, like illustrated in Fig. 1a, the electrodes 112_i, 114_j are embedded in the piezoelectric layer 104 and represent a continuous material from a geometrical point of view although physical properties of the resulting layer are periodically distributed.

As can be seen from the results illustrated below, the signature of the mode is similar to a leaky-SAW propagating at an equivalent phase velocity about 9850m.s⁻¹, thus higher than the surface skimming bulk wave (SSBW) in Silicon Dioxide, being typically around 3750 m.s⁻¹. Indeed, considering the electrical period of the structure to be 2.8µm with a metallization ratio a/p of around 0.43 and the resonance frequency of 3.45GHz, an equivalent velocity of about 9850m.s⁻¹ is achieved. The velocity of the mode is obtained by the product of the resonance frequency 3.45GHz times the electrical period 2.8µm. The velocity of the mode is computed as the sum of frequencies at the beginning and at the end of the stopband times the mechanical period, see further below.

Fig. 3a shows the simulation data obtained for a configuration in which the shear mode of the electrodes, as already illustrated in Figure 2, is excited. The graph represents the conductance G in S units on the left Y axis and the susceptance B in S units on the right Y axis, as a function of the frequency in MHz on the X axis, for both G harmonic and B harmonic. As can be seen, a wide band harmonic admittance is observed, with a shear resonance at 3.45GHz. The shear resonance at 3.45GHz is the predominant excited mode. Furthermore, two much smaller contributions can be seen around 1.5GHz and around 7GHz.

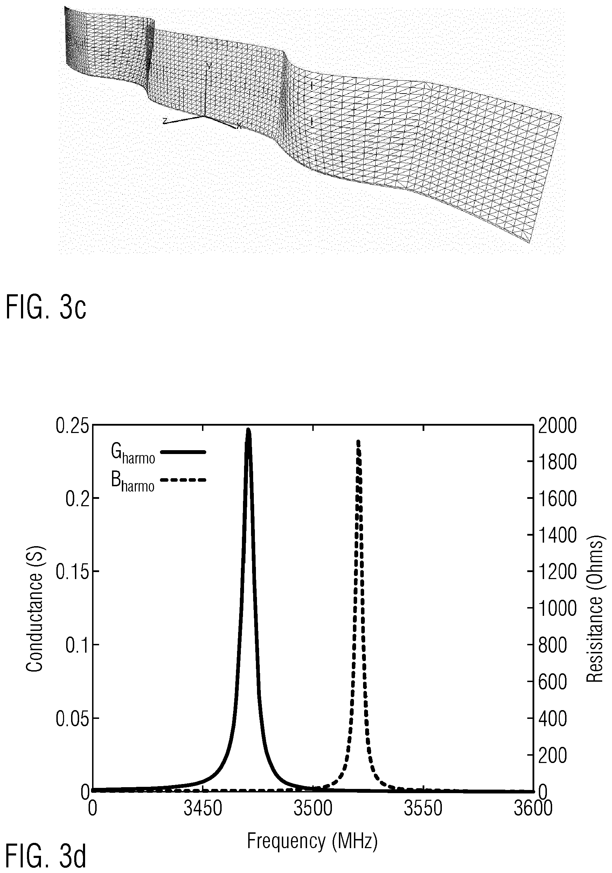

Fig. 3b and 3c illustrate deformations inside the structure of the transducer. The movement is concentrated to the area of the interdigitated electrodes 108, 110 only. The vibrations in the piezoelectric layer 104 were almost not visible in the simulation.

According to the invention, the above-mentioned parameters were such that a shear bulk acoustic mode is excited predominantly within the metal electrode means 112_i, 114_j, polarized in the y direction and yielding a displacement in the z direction, which is also the direction of the electrical field E. Thus, the vibration is mainly located within the electrodes with a deformation close to the fundamental shear bulk wave of the electrode itself. Although shear motion also is observed within the piezoelectric layer 104, the largest vibration magnitude occurs in the electrodes 112_i, 114_j with alternate vibration direction.

The shear displacement direction is alternated from one electrode to another when the transducer 100 is excited by a +V/-V electrical polarization structure. This opposition in phase of the electrodes increases the accumulation of charges at the edge of the electrodes, thus increasing the excitation of the bulk mode in the electrodes 112_i, 114_j. The piezoelectric layer 104 is confining stresses on the electrode edges and the coherence of the vibration occurs when satisfying boundary conditions along the grating since the transducer structure operates at the Bragg conditions. Although shear motion is also present within the piezoelectric layer 104, the largest vibration magnitude occurs in the electrodes with alternate vibration direction from one electrode to the other.

The predominant acoustic wave propagating in the transducer structure is thus a bulk shear wave that is confined within the electrodes 112_i, 114_j. The resonant frequency fᵣ of the transducer structure 100 is given by *fᵣ = v*/*2p = v*/*λ, v* being the acoustic wave propagation velocity in the acoustic wave propagating substrate and *λ* the operating acoustic wavelength of the transducer.

Since the bulk acoustic wave in the electrode means has a resonance at higher frequency than the guided wave in the piezoelectric layer, this transducer structure can work at higher frequencies, in particular above 3GHz. Thus, higher frequencies than with prior art devices can be exploited, without the need to use more sophisticated lithography tools to move to smaller features.

A main aspect of the invention is thus that this type of structure enables the excitation of a shear mode mainly located in the electrode, resembling a shear bulk mode confined within the electrode means, as explained above. The mode can be qualified as a pseudo or leaky mode, that is confined with a leakage which is reduced but not totally suppressed which leads to the synchronization between electrodes. This mode exhibits an equivalent velocity much larger than what is achievable with state of the art inter-digitated transducer structures on composite substrates exploiting the shear mode in the piezoelectric layer. The other modes, are much lower or even suppressed which is mainly due to the use of the Silica substrates with the low SSBW velocity therefore allowing the standard shear mode to dissipate.

Fig. 3d shows a zoom of the simulated wide band harmonic admittance of the excited mode shown in Fig. 3a, according to the first embodiment of the invention.

The graph shown in Fig. 3d represents the conductance in S unit on the left Y axis and the susceptance in S unit on the right Y axis, for a frequency range between 3400 to 3600MHz on the X axis, for both G harmonic and B harmonic. A resonance around 3.475GHz and an anti-resonance around 3.525GHz can be seen. The resonance and anti-resonance are well separated and give a coupling factor of about 3%. The resonance also takes place at the beginning of the stop-band.

In this particular case, a reflection coefficient of about 9%, a quality factor Q of the resonance of about 500, and for anti-resonance of about 1000 are achieved.

The coupling factor can be improved by modifying the characteristics of the transducer structure, such as the aspect ratio a/p, the thickness of the electrodes and the materials used. In particular, the aspect ratio a/p and the thickness of the electrodes enable to control the velocity, the electromechanical coupling, the quality factor or radiation losses and the reflection coefficients.

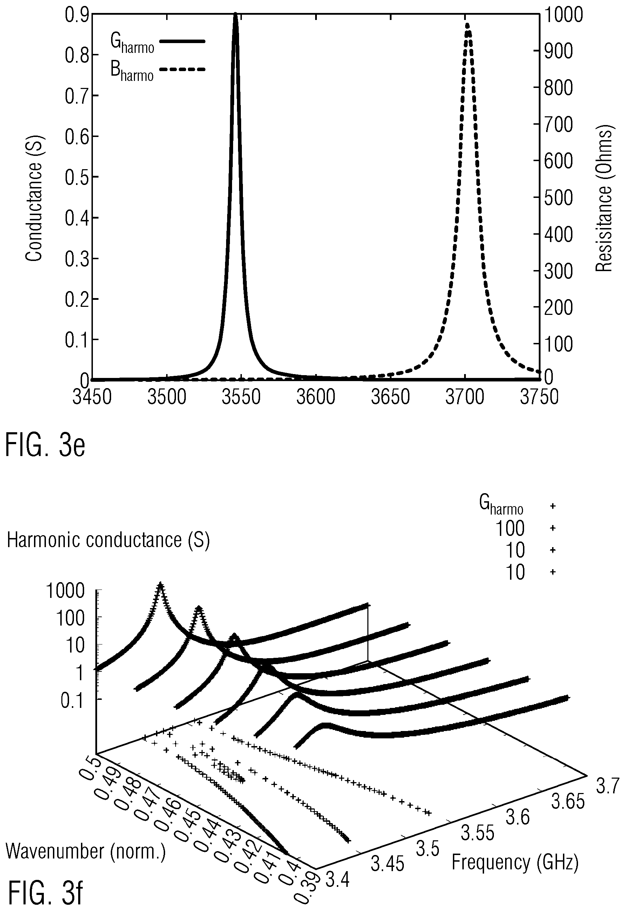

Fig. 3e shows the conductance and resistance of the excited mode for a variant of the first embodiment obtained for the same material choice but a aspect ratio a/p of 0.57.

Also in this configuration the shear mode concentrated inside the electrodes is excited. The graph represents the Conductance in S unit on the left Y axis and the Susceptance in S unit on the right Y axis, for a frequency range between 3450 to 3750MHz on the X axis, for both G harmonic and R harmonic. A resonance around 3.550GHz and an anti-resonance around 3.700GHZ is obtained.

In this case, increasing the aspect ratio a/p from 0.43 to 0.57 leads to an increase in equivalent phase velocity of the propagating mode to more than 10 km.s⁻¹ and to an increase in coupling factor to more than 10%. However, the reflection coefficient is now less than 5%. At resonance, the Q factor is still equal to 500 but at the anti-resonance, the Q factor is now equal to 350.

Fig. 3f illustrates the dispersion properties of the excited mode as illustrated in Fig. 3a, according to the first embodiment of the invention. In that case, the admittance is calculated for various normalized wavelengths near a value of 0.5 corresponding to the edge of the said first Brillouin zone which is also identified as the Bragg condition. For normalized wavelengths smaller than 0.5, the mode is less efficiently excited as one can see on the curve and at lower frequency. Considering this and by plotting the evolution of the maximum admittance moduls versus frequency and normalized wavelength, the projected 2D representation is obtained recalling the classical dispersion curve of any wave propagation in a periodic lattice. As can be seen, the resonance occurs at the beginning of the stop-band.

The choice of the substrate is important when other modes than the shear mode concentrated in the electrodes have to be suppressed or at least are only weak compared to the desired mode. As mentioned above, this condition is obtained when SSBW velocity in the substrate is lower than velocity of the fundamental shear mode in the piezoelectric layer.

Furthermore, the acoustic impedance should be close to the one of the piezoelectric layer to favour the mode.

Still, other substrates with a high acoustic wave propagation velocity equal or larger than 4500m.s⁻¹, like silicon, diamond, sapphire, silicon carbide or aluminium nitride may still be used but in that case the bulk shear mode can exist besides the mode of interest concentrated in the electrodes.

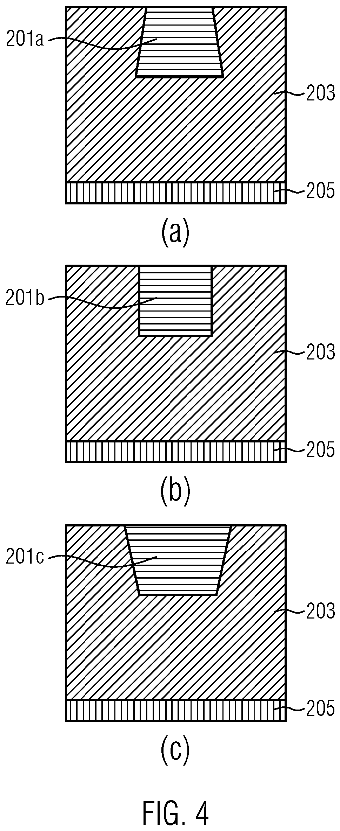

Fig. 4a to Fig. 4c illustrate three variants of such a realisation with three different electrode shapes considered for the excitation of the electrode-resonance mode. In all three figures one mechanical period being represented, the grating is assumed infinitely long and excited by an harmonic +V/-V excitation. The electrodes radiate energy into the bulk substrate from their bottom interface with the substrate.

The Al electrode 201a, 201b, 201c is respectively represented by horizontal crosshatch, the piezoelectric layer 203, here LiTaO₃, is in inclined crosshatch and the bottom layer 205 in vertical crosshatch which can be either SiO₂ or other interface material or the same material as the piezoelectric layer. The electrode 201a is of a pyramid type, the electrode 201b is of a vertical type and the electrode 201c is of a V-groove type. Thus, the electrodes fill grooves of varying shape inside the piezoelectric 203, which behaves like a bulk material.

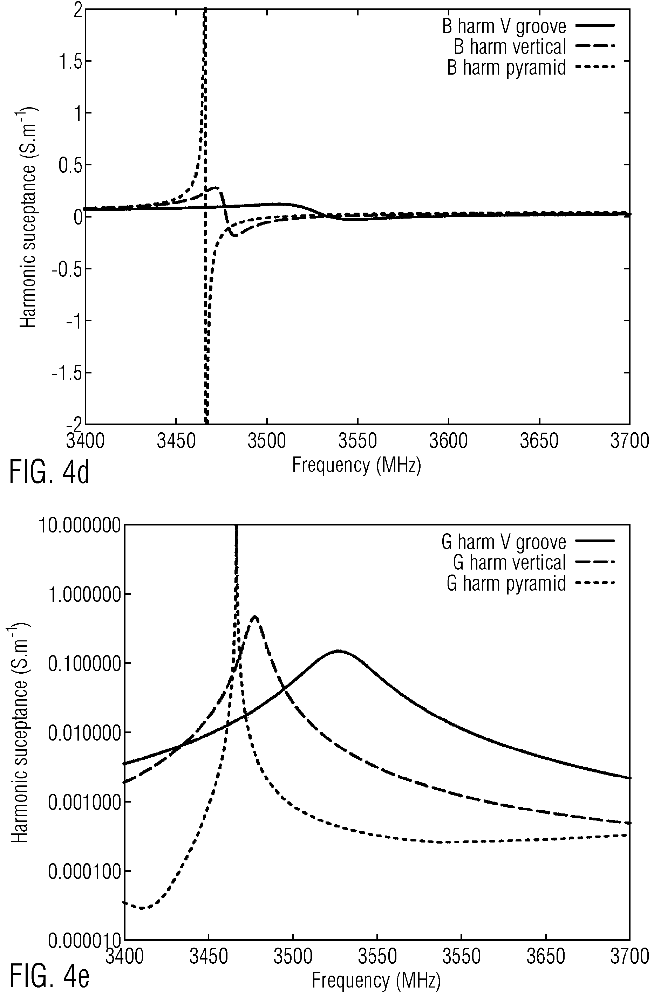

The Figs. 4d and 4e illustrate the results of the simulation and provides a comparison of excitation efficiency of the electrode-resonance mode for the three electrode shapes:
Fig. 4d illustrates the harmonic suceptance and Fig. 4e illustrates the harmonic conductance.

The simulations clearly indicated that the pyramidal shape is of higher interest than the two others with, however, a lower coupling efficiency.

Further design options can be obtained by shaping the side walls of the grooves, e.g. by having concave or convex side walls.

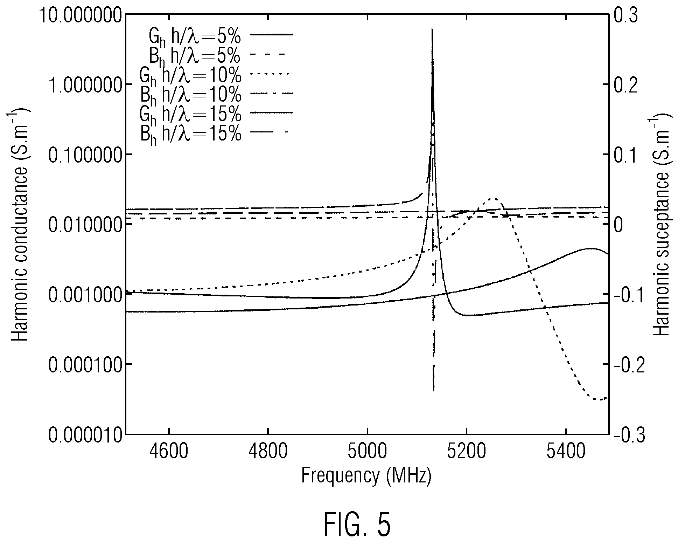

Fig. 5 indicates the effect of the thickness of the electrode means 112_i and 114_j on the shear mode within the electrodes. Here the harmonic analysis for Aluminium electrodes embedded in a (YXI)/42° Lithium Tantalate piezoelectric layer on a 325 nm thick Silicon Dioxide layer on Si(100) are illustrated for a 1 µm pitch and a metal/piezoelectric a/p ratio set to 0.35 is presented. Fig. 5 shows the admittance for a relative metal/layer height h/λ from 5% to 15%. One can identify that only starting at a h/λ ratio larger than 0,1 a resonance can be observed.

Compared to the other examples illustrated above, the resonance occurs at a higher frequency around 5.15 GHz, which is due to the smaller pitch.

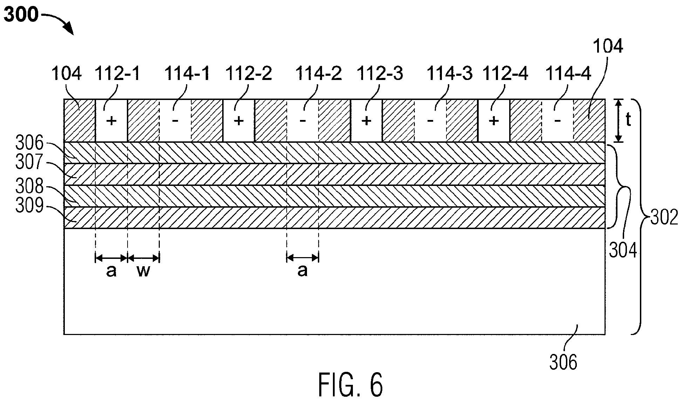

Fig. 6 illustrates an inter-digitated transducer structure for acoustic wave devices according to a fourth embodiment of the invention.

The transducer structure 300 comprises a different acoustic wave propagating substrate 302 in comparison with the substrate 102 of the transducer structure 100 of the first embodiment, which is the only difference with respect to the first embodiment. All other features are the same and will therefore not be described in detail again but reference is made to their description above.

The transducer structure 300 comprises a composite substrate 302 comprising, like the composite substrate 102, a piezoelectric layer 104, formed over the base substrate 306, but furthermore comprises an acoustic mirror 304, also called Bragg mirror, formed above the base substrate 306 and below the piezoelectric layer 104.

The Bragg mirror 304 comprises a plurality of stacked layers 306 to 309, the layers with an even reference numeral 306, 308 being of a first material and the layers with an odd reference numeral 307, 309 being of a second material. The first and second materials have different acoustic impedances, so that the Bragg mirror 304 comprises a stacking of alternating high and low impedance layers.

The Bragg mirror 304 has a periodical repetition of a pair of layers with a thickness of about a quarter of a wavelength with alternating high/low impedances, to ensure the reflection.

The first and second materials can be chosen amongst Tungsten, Molybdenum, LiTaO₃, Al₂O₃, AIN, LiNbO₃, Si₃N₄ and any combination of SiO₂ and Si₃N₄ (known as silicon oxy-nitride and noted SiOₓN_{y} with x and y controlling the amount of each element in the compound) and ZnO, Aluminium or SiO₂.

In a variant, the first material and the second material can be exchanged so that the first material has a low impedance and the second material has a high impedance.

In this embodiment, the Bragg mirror 304 is represented as having four layers 306-309 forming the stack of alternating high and low impedance layers. But, in another variant, the Bragg mirror 304 can also have more or less than four layers of alternating high and low impedance forming the stack.

Increasing the number of pairs in a Bragg mirror 304 increases the mirror reflectivity and increasing the impedance ratio between the materials in the Bragg pairs increases both the reflectivity and the bandwidth. A common choice of materials for the stack is for example Titanium dioxide and Silica.

According to the invention, the piezoelectric layer 104 and the Bragg mirror 304 are arranged such as to reduce the contributions of additional modes present in the structure, to promote a unique mode within the transducer structure 100 to ensure the spectral purity of an acoustic wave device based on such transducer structure 100, preventing spectral pollution.

One approach is to optimize the thicknesses of the stack of the Bragg mirror 304 to promote the unique mode within the transducer structure, and to realize an efficient reflection coefficient for this mode. The Bragg mirror 304 thus acoustically isolates vibrations generated within the electrode means 112, 114 from the base substrate 106.

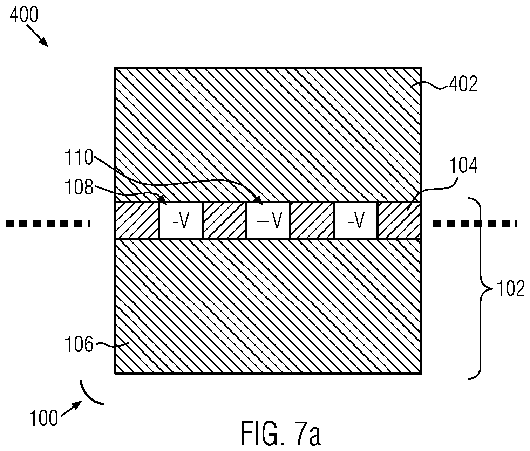

Fig. 7a illustrates an inter-digitated transducer structure for acoustic wave devices according to a fifth embodiment of the invention.

The transducer structure 400 comprises a covering layer 402 on top of the transducer structure 100 of the first embodiment, which is the only difference with respect to the first embodiment. All other features are the same and will therefore not be described in detail again but reference is made to their description above.

The transducer structure 400 comprises a composite substrate 102 comprising a piezoelectric layer 104 formed over the base substrate 106.

In this embodiment of the invention, a layer 402 is present on top of the embedded electrodes 108, 110 and of the piezoelectric layer 104. The layer 402 can be a passivation layer or a guiding substrate, comprising a high velocity low loss material such as Silicon, Sapphire, Garnets i.e. Yttrium-based materials, Aluminium Nitride, Silicon Carbide. The covering layer 402 can also be made of Glass and Silicon substrate based-substrates.

In the embodiment shown in fig. 7a, the covering layer 402 is made of the same material as the base substrate 106 of the composite substrate 102. But, the covering layer 402 can be different from the base substrate of the composite substrate.

According to a further variant, the layer 402 can be present only on top of the electrode means 108, 110, or only on top of the piezoelectric layer 104.

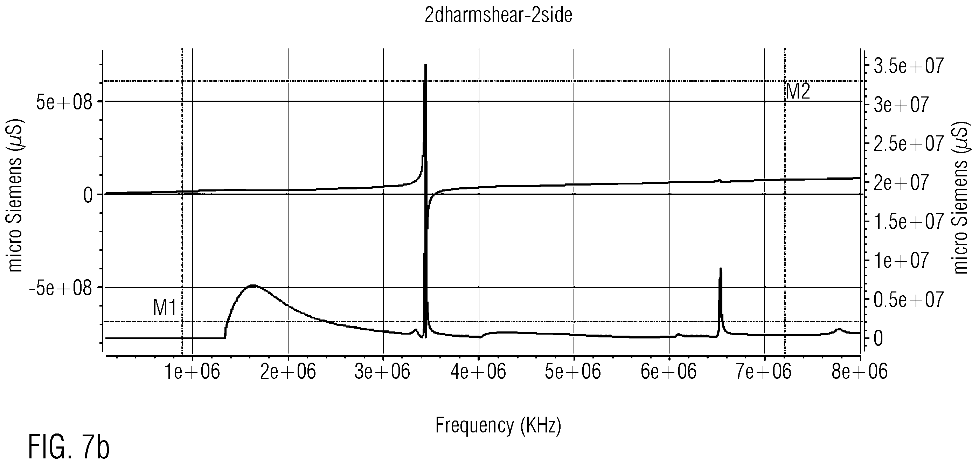

Fig. 7b to Fig. 7d show the simulated wide band harmonic admittance of an excited mode according to the third embodiment of the invention for an acoustic wavelength of 2.8 µm, an a/p ratio of 0,5 with Aluminium electrodes and (YX*l*/42°) Lithium Tantalate as the piezoelectric layer 104.

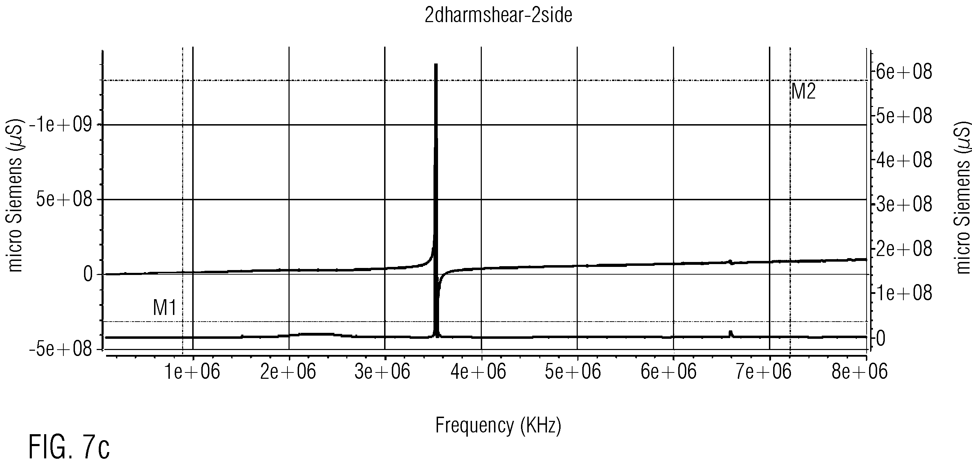

For Fig. 7b, the covering layer 402 and the base substrate 106 is Silicon dioxide. The excited mode occurs at 3.5 GHz. For Fig. 7c, the covering layer 402, the base substrate 106 and the piezoelectric layer 104 is (YX*l*/42°) Lithium Tantalate. The excited mode occurs as well at around 3.5 GHz.

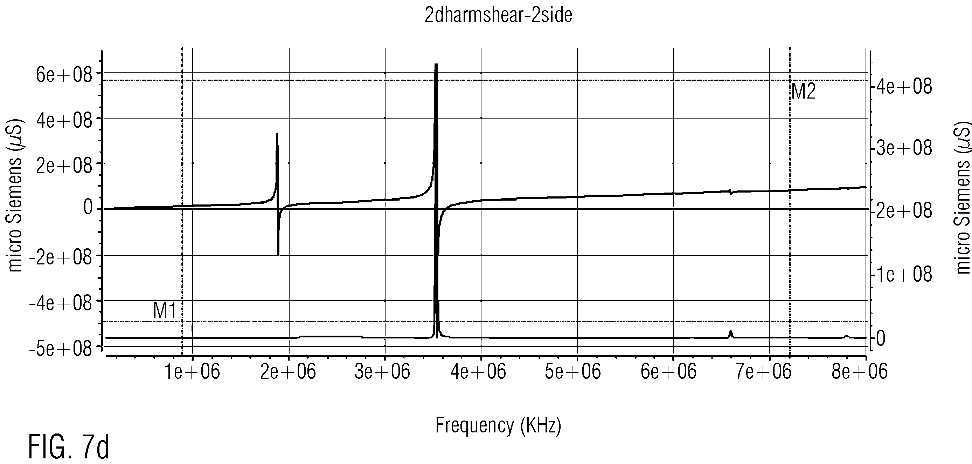

For Fig. 7d, the covering layer 402 and the base substrate 106 is a Silicon substrate. The excited mode occurs at 3.5 GHz, but here the fundamental shear mode in the piezoelectric layer is also excited and visible at lower frequency, namely at about 1.8 GHz.

The invention also relates to an acoustic wave device comprising two transducer structures according to any one of the first and/or the second embodiment of the invention.

In an alternative, only one of the two transducer structures can be a surface acoustic device according to the invention whereas the other one can be according to the state of the art.

The acoustic wave device can be an acoustic wave resonator and/or an acoustic wave filter and/or an acoustic wave sensor and/or a high frequency source.

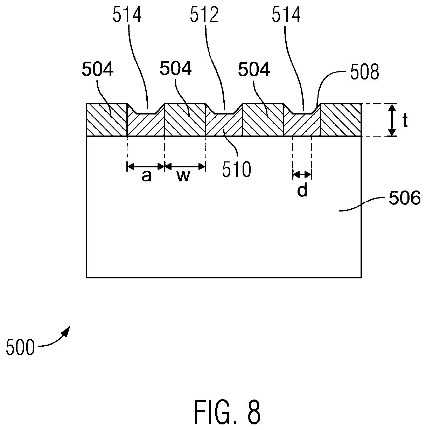

Fig. 8 shows a sixth embodiment of the transducer structure.

The transducer structure 500 of Fig. 8 differs from the transducer structure of Fig. 1 in that the interdigitated electrodes 512, 514 only partially fill the grooves 510 in the piezoelectric regions 504.

According to the manufacturing process, the thickness of the metallic layer is not constant over the entire removed region 510. Due to surface energy properties, the thickness of the metallic layer at the side wall 508 is superior to the thickness within the centre part.

The transducer structure 500 functions in the same way as the transducer structures as described above.

The use of the frequency of the bulk wave propagating in the electrode means of a transducer structure as described above in a acoustic wave device, in particular for a ladder filter and/or impedance filter and/ coupling filter, allows to generate contributions at high frequency, in particular above 3GHz, more in particular above 3,5GHz.

Using such embedded electrode means for the transducer structure, the performance of acoustic wave devices as well as their application ranges can be improved compared to bulk piezoelectric substrates without having to change the manufacturing tools, namely l line lithography.

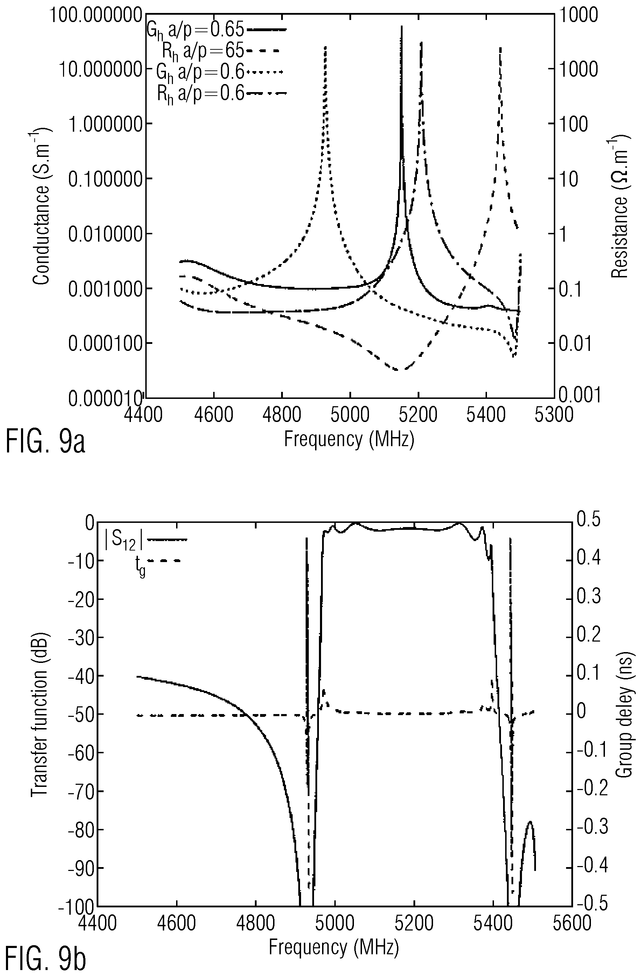

Fig. 9a and Fig. 9b illustrate as seventh embodiment a practical example of a filter illustrating an effective implementation of the invention according to a typical market demand, e.g. for 5G sub-6-GHz (C-band) filtering. The practical example is based on Al electrodes embedded in LiTaO₃ on Silica with the following parameters: pitch p=1µm yielding a wavelength λ of 2 µm thus providing a resonance near 5 GHz, like illustrated in Figure 5 and a thickness of 700nm for the electrodes and the piezoelectric layer, thus a ratio of h/λ of 0,35. According the usual approach of SAW ladder filter design, the resonance of the series branch occurs at anti-resonance of the parallel branch.

This example according to the invention can be manufactured in a single batch using standard SAW manufacturing technology, e.g. using l line lithography and a single metal layer deposition. A fine-tuning of the resonance frequencies using the grating pitch p and/or the aspect ratio a/p and/or the h/λ ratio can be realized. A passivation layer or Bragg mirrors like illustrated in Fig. 7a and Fig 6 might be used as well to improve the characteristics.

The filter of the practical example is based on the basic transducer structure as illustrated in Fig. 1. Based on that resonators are formed and combined in series and parallel to form cells that can be arranged as cascades or as ladder-filter structures like known in the art.

In the practical example, two gratings of 35% with a respective material ratio a/p = 0.6 and 0.65 were used. In both cases, harmonic admittance and impedance were computed and are illustrated in Fig. 9a. The resonance of the a/p=0.65 grating is close to the anti-resonance of the a/p=0.6 grating, which is the prerequisite for the design of a ladder filter as mentioned above.

By combining the responses the transfer function of a 4 π-cell filter as known in the art, can be computed, the result of which is illustrated in Fig. 9b. The transfer function illustrates that an ultra-compact filter operating at more than 5 GHz with electrodes as thick as 700 nm allows improved power handling as the electrodes are embedded according to the invention. In this configuration physical migration is absent. The inventive filter provides a coupling factor *kₛ²* in excess of 10% for LiTaO₃. This could be improved by using LiNbO₃ taking into account the scaling between the two materials.

The proposed design shows a bandwidth of 300 MHz. By tuning the resonance-anti-resonance condition an improved match can lead to high band width of the order of 400 MHz as well. Like mentioned above tuning can consist in adjusting the pitch and/or the ratio a/p.

A number of embodiments of the invention have been described. Nevertheless, it is understood that various modifications and enhancements may be made without departing the following claims.

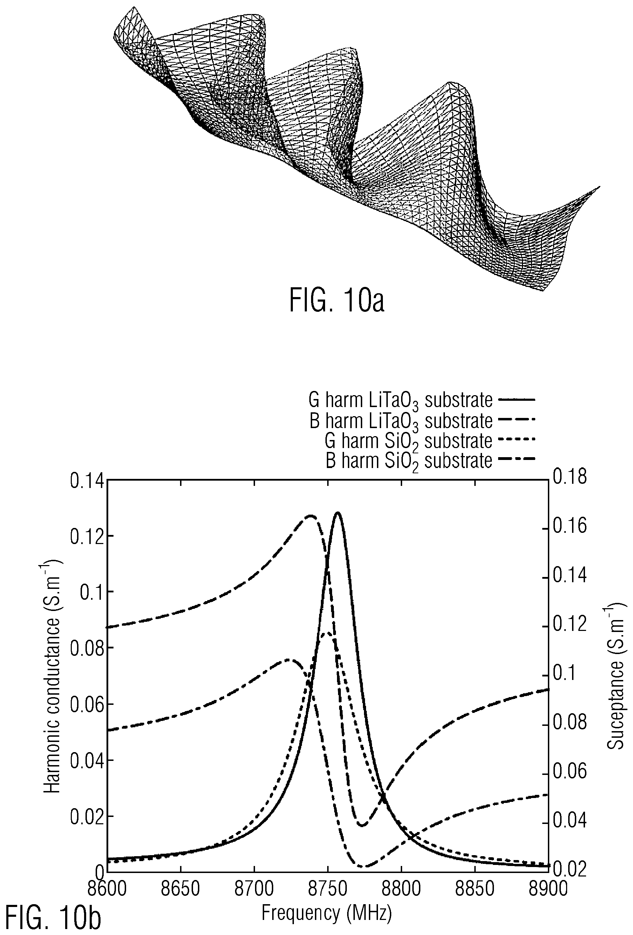

Fig. 10a illustrates that also higher harmonic modes of the shear mode of the electrodes can be excited. Fig. 10a actually illustrates a third harmonic. Figure 10a corresponds to a 700 nm thick Al vertical electrodes, metal ratio a/p is 0.5, pitch is 1.4 µm and the piezoelectric layer LiTaO3 (YXI)/42°. In Figure 10b, comparison is achieved for LTO, Si, SiO2 and Sapphire substrate considering a pyramid shape of the electrode, like illustrated in Fig. 4a, yielding better Q than the other types of electrodes. The other parameters are the same as for Fig. 10a.

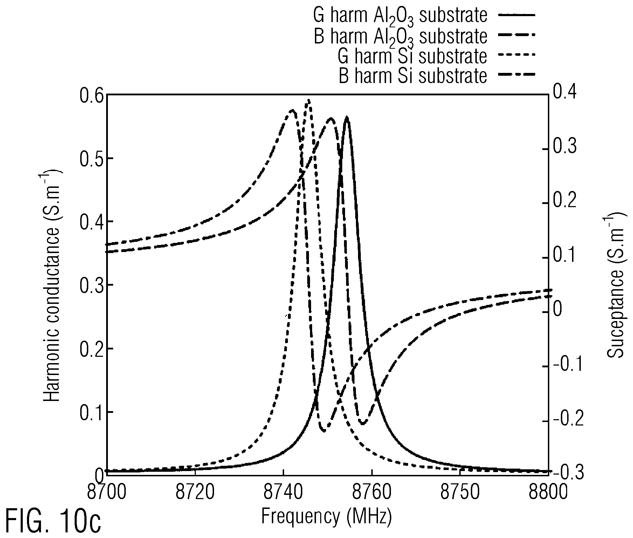

Fig. 10b and Fig. 10c illustrate the corresponding harmonic conductances G and susceptance B for various substrates, LiTaO3, SiO2, Si and sapphire. These modes are of interest as due to the high resonant frequency around 8,75 GHz they show a high equivalent velocity. Using a transducer structure according to the invention to excite the corresponding mode can advantageously be used in the development of high frequency sources.

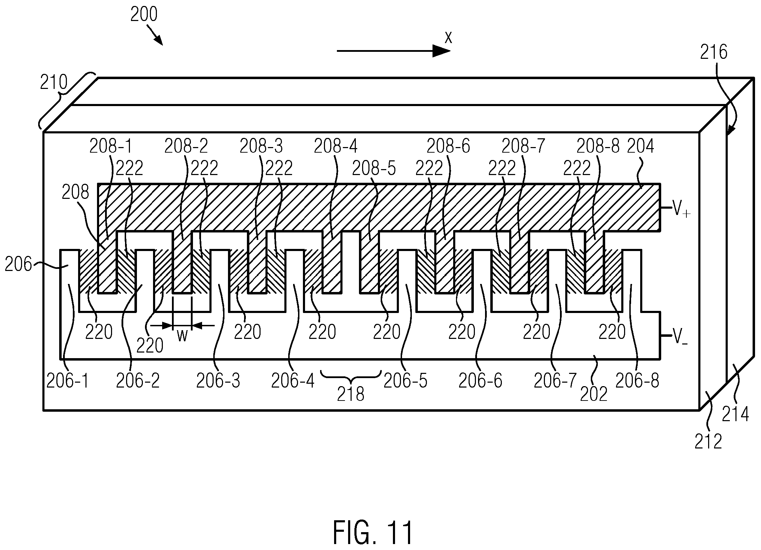

Fig. 11 illustrates an eighth embodiment of the invention in relation to the second object of the invention. It illustrates an inter-digitated transducer structure 200 for a surface acoustic wave device according to a first embodiment of the invention. The inter-digitated transducer structure 200 comprises a pair of inter-digitated comb electrodes 202 and 204 each comprising a plurality of electrode means 206 and 208 that are embedded into the piezoelectric layer 212.

Like in the first embodiment, the electrode means 206 and 208 have the shape of fingers 206, 208. In a variant of the embodiment, the electrode means could also have spilt fingers 206, 208 comprising each two or more directly adjacent electrode fingers belonging to the same comb electrode.

The piezoelectric layer 212 is part of a composite substrate 210 further comprising a base substrate 214. The piezoelectric layer is of the same material and also has the same properties with respect to thickness as described in the other embodiments.

The thickness of the base substrate 214 can be larger than the thickness of the piezoelectric layer 212 to impose its thermal expansion to the piezoelectric layer 212 and to reduce the transducers sensitivity to temperature changes. A preferred situation corresponds to a base substrate thickness that is at least ten times larger than the thickness of the piezoelectric layer 212.

The base substrate 214 is of the same material as in the first embodiments.

By using a different material for the base substrate 214, the flexibility in the design can be enhanced.

The pair of inter-digitated comb electrodes 202 and 204 comprises a plurality of electrode fingers 206 and 208. The electrode fingers, for example 206_1,208_1 to 206_4, 208_4 respectively and 208_5, 206_7 to 208_8, 206_10 are inter-digitated and are connected to alternating potentials via their comb electrodes 202 and 204 and embedded in the piezoelectric layer 212. The alternating potential can be +V and -V as illustrated or in a variant a mass and a load/source potential. The electrode fingers are metallic and all have the same length I, width w, and thickness t. Furthermore, also here an electrode pitch p, defined as λ/2, is used for the transducer structure 200. The number of electrode fingers is not fixed and the device can comprise more or less than illustrated in Fig. 11.

According to a variant of the invention, the electrode fingers 206, 208 can also have different length I, width w and thickness tₑ.

Like in the first embodiments, the thickness te is equal or less than the thickness of the piezoelectric layer 212.

The eight embodiment has the particularity in that the transducer structure 200 further comprises a region 218, where two neighbouring electrode fingers 208_4 and 208_5 are connected to the same potential, here +V, without any electrode fingers 206 from the opposing inter-digitated comb electrode 202 inbetween. The two neighbouring electrode fingers 208_4 and 208_5 can also be connected to -V, or to mass, or to a load/source potential VIN (not shown).

In the variant where the electrode means 206, 208 are represented by split fingers 206, 208 of two or more adjacent fingers at the same potential, two neighbouring electrode means 206, 208 connected to the same potential can refer to all fingers of the split fingers 206, which are connected to the same potential of the split fingers 208. But it could also be that at least one electrode finger of the split fingers 206 is connected to the same potential of the split fingers 208.

In Fig. 11, the region 218 is actually placed in the middle of the transducer structure 200, so that on each side, left and right, of the region 218, eight electrode fingers or four electrode finger pairs are present. In a variant of the embodiment, the region 218 can be placed at a different position in the transducer structure, so that the electrode finger pairs are distributed not evenly on either side of the region 218. The region 218 can also be placed on either extremity end of the transducer structure 200.

As mentioned previously, the electrode fingers 206_1, 208_1 to 206_4, 208_4 respectively and 208_5, 206_5 to 208_8, 206_8 are inter-digitated and have alternating potentials. It can actually be seen, that due to the presence of the region 218, on the left side of the region 218, the inter-digitated electrode fingers 206_1, 208_1 to 206_4, 208_4 are at alternating potential -V /+V respectively, while on the right side of the region 218, the inter-digitated electrode fingers 208_5, 206_5 to 208_8, 206_8 are at alternating potential +V / -V respectively.

A pair of neighbouring electrode fingers connected at alternating potential defines an electroacoustic source. For example, here in Fig. 11, the neighbouring inter-digitated electrode fingers 206_1 and 208_1 at alternating potential -V / +V define an electro-acoustic source 220. But the neighbouring inter-digitated electrode fingers 208_1 and 206_2 at alternating potential +V / -V define also an electro-acoustic source 222. Thus, the pair of neighbouring inter-digitated electrode fingers 206_2, 208_2 to 206_4, 208_4 each also defines an electro-acoustic source 220 and respectively, the pair of neighbouring inter-digitated electrode fingers 208_2, 206_3 and 208_3, 206_4 each also defines an electro-acoustic source 220. In particular, here, on the left of the region 218, four active electro-acoustic sources 220 and three active electro-acoustic sources 222, with in total eight inter-digitated electrode fingers 206_1, 208_1 to 206_4, 208_4 are present.

On the right side of the region 1218, a pair of neighbouring inter-digitated electrode fingers, for example 208_5 and 206_5 connected at alternating potential +V/-V defines also an electroacoustic source 222, and the pair of neighbouring inter-digitated electrode fingers 206_5 and 208_6 at alternating potential -V/+V define an electro-acoustic source 220. On the right side of the region 218, four active electro-acoustic sources 222 and three active electroacoustic sources 220, with in total eight inter-digitated electrode fingers 208_5, 206_5 to 208_8, 206_8 are present. But here, the electro-acoustic sources 220, 222 on the left side of the region 218 are in opposition of phase with the electro-acoustic sources 222, 220 on the right side of the region 218, in particular of π.

However, as the electrode pitch *p* is defined as λ/2, this signifies that the transducer structure 200 is operating in a synchronous mode, at the Bragg condition. Therefore, the plurality of electro-acoustic sources 220, 222 on the left side of the region 218 are all in phase and coherent with each other, while the plurality of electro-acoustic sources 222, 220 on the right side of the region 218 are all in phase and coherent with each other.

In the region 218, there is no electro-acoustic source 220 or 222 between the two neighbouring electrode fingers 208_4 and 208_5, as they are both connected to the same potential.

According to a variant, the polarity of the potential could be swapped between the first and second inter-digitated comb electrodes 206 and 208, or connected to mass on the one comb electrode and a load/source potential VIN on the other comb electrode.

Due to the presence of the second region 218 in the transducer structure 200, the phase of the electro-acoustic sources within the transducer has been inverted by π, as the electro-acoustic sources on the left side of the region 218 are in opposition of phase with the electro-acoustic sources on the right side of the region 218. Thus, destructive interference is created between the electro-acoustic sources in the transducer by combining the energy emitted from each side of the two electrode fingers connected to the same comb electrode toward the transducer, whereas the energy emitted toward the outside of the transducer will actually be launched and reflected by the mirror, positioned on either side of the transducer structure in a SAW device.

Therefore the amount of electro-acoustic sources present in the transducer structure 200 being coherent and in phase in the transducer structure 200 is reduced compared to a transducer structure of the same size, where all the electrode fingers are at alternating potentials, as e.g. shown in Fig 1. As a consequence, the electromechanical coupling coefficient ks² in the transducer structure has been reduced.

Here, in this particular embodiment, the left and right side of the region 218 in the transducer structure 200 have exactly the same number of inter-digitated electrode fingers 206 and 208, namely eight, resulting in seven active electro-acoustic sources, as the region 218 is located in the middle of the transducer structure 200. Here, the electromechanical coupling coefficient ks² in the transducer structure 200 is reduced by a factor 2. Again, as destructive interference is created between the electro-acoustic sources in the transducer structure, by combining the energy emitted from each side of the two electrode fingers connected to the same comb electrode toward the transducer, whereas the energy emitted toward the outside of the transducer will actually be launched and reflected by the mirror. The transducer efficiency is therefore reduced by a factor of two.

Furthermore, the possibility of phase coherence of the modes being reflected at the interface 216 of the composite substrate 212 is also modified compared to the prior art situation. If the phase is shifted within the transducer structure, there is no chance to detect waves which do not match the phase matching condition. Therefore, there is a reduction in detection of the reflected acoustic waves from the interface 216, which will in turn lead to a reduction of the parasitic resonances at unwanted frequencies due to these reflections in the filter performance of a SAW device based on a transducer structure 200.

Therefore, the generation and/or detection of acoustic waves in the transducer structure 200 according to the invention is controlled by the amount of electro-acoustic sources in phase present in the transducer structure 200. By having two neighbouring electrode fingers connected to the same potential results in a phase change of π within the structure which has a positive influence on the efficiency of the transducer structure to reject parasitic modes. It is not needed to vary the dimensions of the transducer, such as width or length or interelectrode distance of the electrode fingers, which would have an impact on the fabrication technology of such structures and might significantly reduce the quality of the resonance of a resonator exploiting the above described transducer structures.

According to a variant of the eighth embodiment, more than just one region 218 could be present in the transducer structure, therefore increasing the number of suppressed electro15 acoustic sources in the transducer structure and thereby decreasing the electromechanical coupling coefficient *kₛ²* further. This is an efficient way to control the bandwidth of the filter, thus giving more degree of freedom to address various filter bands.

According to another variant more than just two neighbouring electrode means 208_4 and 208_5, like three or more, could be linked to the same potential, thereby suppressing further sources. In addition, or according to another variant, more than one region with suppressed sources could be present. In that case it would be advantageous to distribute them in a random manner over the extension of the transducer structure. In case there are more regions, the number of neighbouring electrode means linked to the same potential is different.

A number of embodiments of the invention have been described. Nevertheless, it is understood that various modifications and enhancements may be made without departing from the invention which is defined by the appended claims.

## Claims

1. A transducer structure (100, 200, 300, 408, 410) for an acoustic device comprising:
a piezoelectric layer (104) provided over a base substrate (106),
a pair of inter-digitated comb electrodes (108, 110, 412, 414), comprising a plurality of electrode means (112_i, 114_j, 418, 420) with a pitch *p* satisfying the Bragg condition given by *p=* λ/2, λ being the operating acoustic wavelength of said transducer,
and wherein the inter-digitated comb electrodes (108, 110, 412, 414) are embedded in the piezoelectric layer (104);
said pair of inter-digitated comb electrodes (202, 204) comprises neighbouring electrode means (206, 208) belonging to different comb electrodes (202, 204) wherein the electrode means (206, 208) all have the same cross sectional shape;
said pair of inter-digitated comb electrodes (202, 204) comprises one region (218) or more regions in which two or more neighbouring electrode means (206, 208) belong to the same comb electrode (202, 204) while having a pitch p;
the thickness of the embedded electrode means (112_i, 114_j, 418, 420) is equal to the thickness of the piezoelectric layer (104); and
the acoustic impedance of the base substrate (106) is within the range of [-25%, 25%] of the acoustic impedance of the piezoelectric layer (104).

2. Transducer structure according to claim 1, wherein the acoustic impedance of the electrode means is less than the acoustic impedance of the piezoelectric layer.

3. Transducer structure according to claim 1 or 2, wherein the aspect ratio a/p, with "a" the width and "p" the pitch of the electrode means (112_i, 114_j, 418, 420), is comprised between 0,3 and 0,75, in particular between 0,4 and 0,65.

4. Transducer structure according to one of the claims 1 to 3, wherein the thickness tₑ of the electrode means satisfies *λ > tₑ > 0,1*λ .*

5. Transducer structure according to any one of the previous claims 1 to 4, further comprising a Bragg mirror (204) underneath the piezoelectric layer (104) and/or the electrode means.

6. Transducer structure according to any one of the previous claims 1 to 5, further comprising a covering layer (302) on top of the embedded electrode means (112_i, 114_j, 418, 420) and the piezoelectric layer (104).

7. Transducer structure according to one of claims 1 to 6, wherein the embedded electrodes are filled into pyramidal or V- or U-shaped grooves in the piezoelectric layer and/or wherein the side walls of the grooves have a convex or concave shape.

8. Transducer structure according to one of claims 1 to 7, wherein the electrode means is made of a material that is lighter than Manganese, in particular Aluminum or an aluminum alloy comprising Cu, Si or Ti.

9. Transducer structure according to one of claims 1 to 8, wherein the piezoelectric layer is Lithium Tantalate or Lithium Niobate.

10. Transducer structure according to claim 9, wherein the base substrate and/or the covering layer (302) is Silica, quartz, fused quartz or glass or LiTaO₃ or LiNbO₃.

11. Transducer structure according to one of claims 1 to 10, wherein regions (218) with two or more neighbouring electrode means (206) belonging to the same comb electrode (202, 204) are non-periodically distributed over the extension of the transducer structure.

12. Transducer structure according to claim 10 or 11, wherein regions (218) with two or more neighbouring electrode means (206, 208) belonging to the same comb electrode (202, 204) have different numbers of neighbouring electrode means belonging to the same comb electrode.

13. Acoustic wave device (400) comprising at least one transducer structure (100, 200, 300, 408, 410) according to anyone of the claims 1- 12, wherein the device (400) is an acoustic wave resonator, and/or an acoustic wave filter and/or an acoustic wave sensor and/or a frequency source.

14. Method of using a transducer structure according to one of claims 1 to 13, comprising a step of applying an alternating potential to the two interdigitated electrodes configured to excite a shear wave mode predominantly occurring within the electrode means compared to the piezoelectric layer, said shear wave mode having an equivalent velocity higher than the fundamental shear wave mode of the piezoelectric layer.

15. Method according to claim 14, wherein the transducer structure is part of a filter, in particular a ladder filter and/or impedance filter and/or coupling filter, or a resonator or a delay line or a sensor.

## Patentansprüche

1. Wandlerstruktur (100, 200, 300, 408, 410) für eine akustische Vorrichtung, welche umfasst:
eine piezoelektrische Schicht (104), die über einem Basissubstrat (106) bereitgestellt ist, ein Paar ineinandergreifender Kammelektroden (108, 110, 412, 414), die eine Vielzahl von Elektrodenmitteln umfassen (112_i, 114_j, 418, 420), mit einem Abstand p, der die Bragg-Bedingung erfüllt, welche durch *p* = *λ*² gegeben ist, wobei *λ* die akustische Betriebswellenlänge des Wandlers ist,
und wobei die
ineinandergreifenden Kammelektroden (108, 110, 412, 414) in die piezoelektrische Schicht (104) eingebettet sind,
das Paar ineinandergreifender Kammelektroden (202, 204) benachbarte Elektrodenmittel (206, 208) umfasst, welche zu unterschiedlichen Kammelektroden (202, 204) gehören, wobei die Elektrodenmittel (206, 208) alle die gleiche Querschnittsform aufweisen, das Paar ineinandergreifender Kammelektroden (202, 204) einen Bereich (218) oder mehrere Bereiche umfasst, in denen zwei oder mehr benachbarte Elektrodenmittel (206, 208) zur selben Kammelektrode (202, 204) gehören und dabei einen Abstand *p* aufweisen,
die Dicke der eingebetteten Elektrodenmittel (112_i, 114j, 418, 420) der Dicke der piezoelektrischen Schicht (104) entspricht, und
die akustische Impedanz des Basissubstrats (106) innerhalb des Bereichs von [-25 %, 25 %] der akustischen Impedanz der piezoelektrischen Schicht (104) liegt.

2. Wandlerstruktur gemäß Anspruch 1, wobei die akustische Impedanz der Elektrodenmittel kleiner ist als die akustische Impedanz der piezoelektrischen Schicht.

3. Wandlerstruktur gemäß Anspruch 1 oder 2, wobei das Seitenverhältnis a/p, wobei "a" die Breite und "p" der Abstand der Elektrodenmittel (112_i, 114j, 418, 420) sind, zwischen 0,3 und 0,75, insbesondere zwischen 0,4 und 0,65, umfasst ist.

4. Wandlerstruktur gemäß einem der Ansprüche 1 bis 3, wobei die Dicke tₑ der Elektrodenmittel λ > *tₑ >* 0,1*λ erfüllt.

5. Wandlerstruktur gemäß einem der vorstehenden Ansprüche 1 bis 4, die ferner einen Bragg-Spiegel (204) unterhalb der piezoelektrischen Schicht (104) und/oder der Elektrodenmittel umfasst.

6. Wandlerstruktur gemäß einem der vorstehenden Ansprüche 1 bis 5, welche ferner eine Deckschicht (302) auf der Oberseite der eingebetteten Elektrodenmittel (112_i, 114_j, 418, 420) und der piezoelektrischen Schicht (104) umfasst.

7. Wandlerstruktur gemäß einem der Ansprüche 1 bis 6, wobei die eingebetteten Elektroden in pyramidenförmige oder V- oder U-förmige Nuten in der piezoelektrischen Schicht eingefüllt sind und/oder wobei die Seitenwände der Nuten eine konvexe oder konkave Form aufweisen.

8. Wandlerstruktur gemäß einem der Ansprüche 1 bis 7, wobei die Elektrodenmittel aus einem Material bestehen, das leichter ist als Mangan, insbesondere aus Aluminium oder einer Aluminiumlegierung, die Cu, Si oder Ti umfasst.

9. Wandlerstruktur gemäß einem der Ansprüche 1 bis 8, wobei die piezoelektrische Schicht Lithiumtantalat oder Lithiumniobat ist.

10. Wandlerstruktur gemäß Anspruch 9, wobei das Basissubstrat und/oder die Deckschicht (302) Siliziumdioxid, Quarz, Quarzglas oder Glas oder LiTaO3 oder LiNbO3 ist.

11. Wandlerstruktur gemäß einem der Ansprüche 1 bis 10, wobei Bereiche (218) mit zwei oder mehr benachbarten Elektrodenmitteln (206), die zu derselben Kammelektrode (202, 204) gehören, über die Ausdehnung der Wandlerstruktur unregelmäßig verteilt sind.

12. Wandlerstruktur gemäß Anspruch 10 oder 11, wobei Bereiche (218) mit zwei oder mehr benachbarten Elektrodenmitteln (206, 208), die zu derselben Kammelektrode (202, 204) gehören, unterschiedliche Anzahlen benachbarter Elektrodenmittel aufweisen, welche zu derselben Kammelektrode gehören.

13. Akustikwellenvorrichtung (400), die mindestens eine Wandlerstruktur (100, 200, 300, 408, 410) gemäß einem der Ansprüche 1 - 12 umfasst, wobei die Vorrichtung (400) ein Akustikwellenresonator und/oder ein Akustikwellenfilter und/oder ein Akustikwellensensor und/oder eine Frequenzquelle ist.

14. Verfahren zum Verwenden einer Wandlerstruktur gemäß einem der Ansprüche 1 bis 13, umfassend einen Schritt des Anlegens einer Wechselspannung an die beiden ineinandergreifenden Elektroden, die so konfiguriert sind, dass sie einen Scherwellenmodus anregen, welcher im Vergleich zur piezoelektrischen Schicht vorwiegend innerhalb der Elektrodenmittel auftritt, wobei der Scherwellenmodus eine äquivalente Geschwindigkeit aufweist, die höher ist als der fundamentale Scherwellenmodus der piezoelektrischen Schicht.

15. Verfahren gemäß Anspruch 14, wobei die Wandlerstruktur Teil eines Filters, insbesondere eines Leiterfilters und/oder eines Impedanzfilters und/oder eines Kopplungsfilters, oder eines Resonators oder einer Verzögerungsleitung oder eines Sensors ist.

## Revendications

1. Structure de transducteur (100, 200, 300, 408, 410) pour un dispositif acoustique comprenant :
une couche piézoélectrique (104) disposée sur un substrat de base (106),
une paire d'électrodes à peigne interdigitées (108, 110, 412, 414), comprenant une pluralité de moyens d'électrode (112_i, 114_j, 418, 420) ayant un pas *p* satisfaisant à la condition de Bragg donnée par *p = λ*/*2*, *λ* étant la longueur d'onde acoustique de fonctionnement dudit transducteur,
et dans laquelle les électrodes à peigne interdigitées (108, 110, 412, 414) sont enfouies dans la couche piézoélectrique (104) ;
ladite paire d'électrodes à peigne interdigitées (202, 204) comprend des moyens d'électrode voisins (206, 208) appartenant à des électrodes à peigne différentes (202, 204), dans laquelle les moyens d'électrode (206, 208) ont tous la même forme en coupe transversale ;
ladite paire d'électrodes à peigne interdigitées (202, 204) comprend une région (218) ou plusieurs régions dans lesquelles deux moyens d'électrode voisins (206, 208) ou plus appartiennent à la même électrode à peigne (202, 204) tout en ayant un pas *p* ;
l'épaisseur des moyens d'électrode enfouis (112_i, 114_j, 418, 420) est égale à l'épaisseur de la couche piézoélectrique (104) ; et
l'impédance acoustique du substrat de base (106) est dans la plage de [-25 %, 25 %] de l'impédance acoustique de la couche piézoélectrique (104).

2. Structure de transducteur selon la revendication 1, dans laquelle l'impédance acoustique des moyens d'électrode est inférieure à l'impédance acoustique de la couche piézoélectrique.

3. Structure de transducteur selon la revendication 1 ou 2, dans laquelle le rapport d'aspect a/p, « a » étant la largeur et « p » étant le pas des moyens d'électrode (112_i, 114_j, 418, 420), est compris entre 0,3 et 0,75, en particulier entre 0,4 et 0,65.

4. Structure de transducteur selon l'une des revendications 1 à 3, dans laquelle l'épaisseur tₑ des moyens d'électrode satisfait à *λ > tₑ > 0,1*λ.*

5. Structure de transducteur selon l'une quelconque des revendications précédentes 1 à 4, comprenant en outre un miroir de Bragg (204) sous la couche piézoélectrique (104) et/ou les moyens d'électrode.

6. Structure de transducteur selon l'une quelconque des revendications précédentes 1 à 5, comprenant en outre une couche de recouvrement (302) sur le dessus des moyens d'électrode enfouis (112_i, 114_j, 418, 420) et de la couche piézoélectrique (104).

7. Structure de transducteur selon l'une des revendications 1 à 6, dans laquelle les électrodes enfouies sont remplies dans des rainures de forme pyramidale ou en V ou en U dans la couche piézoélectrique et/ou dans laquelle les parois latérales des rainures présentent une forme convexe ou concave.

8. Structure de transducteur selon l'une des revendications 1 à 7, dans laquelle les moyens d'électrode sont constitués d'un matériau plus léger que le manganèse, en particulier de l'aluminium ou un alliage d'aluminium comprenant Cu, Si ou Ti.

9. Structure de transducteur selon l'une des revendications 1 à 8, dans laquelle la couche piézoélectrique est du tantalate de lithium ou niobate de lithium.

10. Structure de transducteur selon la revendication 9, dans laquelle le substrat de base et/ou la couche de recouvrement (302) est en silice, quartz, quartz fondu ou verre, ou LiTaO₃ ou LiNbO₃.

11. Structure de transducteur selon l'une des revendications 1 à 10, dans laquelle des régions (218) ayant deux moyens d'électrode voisins (206) ou plus appartenant à la même électrode à peigne (202, 204) sont réparties de manière non périodique sur l'étendue de la structure de transducteur.

12. Structure de transducteur selon la revendication 10 ou 11, dans laquelle des régions (218) ayant deux moyens d'électrode voisins (206, 208) ou plus appartenant à la même électrode à peigne (202, 204) présentent des nombres différents de moyens d'électrode voisins appartenant à la même électrode à peigne.

13. Dispositif à ondes acoustiques (400) comprenant au moins une structure de transducteur (100, 200, 300, 408, 410) selon l'une quelconque des revendications 1 à 12, dans lequel le dispositif (400) est un résonateur à ondes acoustiques, et/ou un filtre à ondes acoustiques et/ou un capteur à ondes acoustiques et/ou une source de fréquence.

14. Procédé d'utilisation d'une structure de transducteur selon l'une des revendications 1 à 13, comprenant une étape d'application d'un potentiel alternatif aux deux électrodes interdigitées configurées pour exciter un mode d'onde de cisaillement se produisant principalement dans les moyens d'électrode par comparaison à la couche piézoélectrique, ledit mode d'onde de cisaillement ayant une vitesse équivalente supérieure à celle du mode fondamental d'onde de cisaillement de la couche piézoélectrique.

15. Procédé selon la revendication 14, dans lequel la structure de transducteur fait partie d'un filtre, en particulier un filtre en échelle et/ou un filtre d'impédance et/ou un filtre de couplage, ou d'un résonateur, ou d'une ligne à retard ou d'un capteur.
